# EUROPEAN PATENT APPLICATION

(11) **EP 4 538 795 A1**
(43) Date of publication of application: **16.04.2025**
(21) Application number: 23940927.9
(22) Date of filing: 22.12.2023
(51) Int. Cl.: G03F 7/00, G02B 5/18, G02B 6/00

(54) **NANOIMPRINT MASTER, AND OPTICAL WAVEGUIDE AND MANUFACTURING METHOD THEREFOR**

(30) Priority: 31.08.2023 CN 202311118170
(71) Applicant: Sunny Omnilight Nanooptics Information Technology Co., Ltd., Shanghai 200135 (CN)
(72) Inventor: ZHANG, Xueying, Shanghai 200135 (CN); XU, Jingnan, Shanghai 200135 (CN); WEI, Feng, Shanghai 200135 (CN); SHEN, Jiang, Shanghai 200135 (CN)
(74) Representative: Petraz, Gilberto Luigi
(86) International application number: PCT/CN2023/141058
(87) International publication number: WO 2025/043992

(57) **Abstract**

A nano imprint master, an optical waveguide and method for preparing the same. The nano imprint master includes: a grating structure region; a non-grating structure region, wherein the non-grating structure region is disposed around the grating structure region; and a sinking structure, wherein the sinking structure is disposed at a position adjacent to the grating structure region in the non-grating structure region, and the sinking structure extends around a circumference of the grating structure region to surround the grating structure region.

## Description

### CROSS-REFERENCE TO RELATED APPLICATION

This application claims priority to Chinese patent application No. 202311118170.5, filed on August 31, 2023, and titled "NANO IMPRINT MASTER, OPTICAL WAVEGUIDE, AND METHOD FOR PREPARING SAME", the content of which is hereby incorporated by reference in its entirety.

### TECHNICAL FIELD

The present disclosure relates to the field of nano imprint technology, in particular, to a nano imprint master and an optical waveguide and a method for preparing the same.

### BACKGROUND

Nano imprint technology is a new type of micro-nano fabrication technology, which is to transfer a micro-nano image structure onto a corresponding substrate via a template. The nano imprint technology can break through the difficulties of photolithography in the process of reducing a feature size reduction, with advantages of feature size up to the nanoscale, high resolution, and low cost. With the development and upgrading of AR/VR industry, a manufacturing technique for producing optical waveguide production by method of nano imprinting technology is gradually industrialized. However, there are some process difficulties in preparing optical waveguide products by nano imprint technology. In an edge of grating structure area of a product produced by method of nano imprint, due to the large height difference between the grating structure area and the non-grating structure area, the substrate cannot be completely adhered to the substrate, resulting in defects such as poor edges of the grating structure area and uneven residual adhesive, which seriously affects the optical display performance of the optical waveguide.

### SUMMARY

A nano imprint master, an optical waveguide and a method for preparing the same are provided in conjunction with embodiments of the present disclosure.

In one aspect, a nano imprint master is provided in the present disclosure, the imprint master includes: a grating structure region; a non-grating structure region, wherein the non-grating structure region is disposed around the grating structure region; and a sinking structure, wherein the sinking structure is disposed at a position adjacent to the grating structure region in the non-grating structure region, and the sinking structure extends around a circumference of the grating structure region to surround the grating structure region.

In some embodiments, a distance between an inner edge of the sinking structure and an outer edge of the grating structure region is in a range of 0.01 µm to 1000 µm.

In some embodiments, a processing width of the sinking structure is greater than or equal to 0.01 µm.

In some embodiments, a processing depth of the sinking structure is in a range of 0.01 µm to 100 µm.

In some embodiments, the sinking structure includes an independent ring-shaped groove curving from a surface of the non-grating structure region.

In some embodiments, a depth of the ring-shaped groove is equal to a theoretical depth of the sinking structure.

In some embodiments, the theoretical depth of the sinking structure is defined as Δ*H,* and the theoretical depth Δ*H* of the sinking structure satisfies with a following formula: Δ*H*=H1***(1-L/P); a height of a grating in the grating structure region is defined as *H*₁, a line width of a gritting in the grating structure region is defined as *L,* and a period of a grating in the grating structure region is defined as *P*.

In some embodiments, the sinking structure includes a plurality of ring-shaped grooves curving from a surface of the non-grating structure region, and the plurality of ring-shaped grooves are in communication with each other, and depths of the plurality of ring-shaped grooves successively reduces from the inside out to define a step-shaped groove.

In some embodiments, a depth difference of adjacent two of the plurality of ring-shaped grooves is equal to an allowable depth of a substrate, and an allowable depth of the substrate is defined by a material of the substrate and a thickness of the substrate.

In some embodiments, the number of the plurality of ring-shaped groove is defined as N, and the number N of the plurality of ring-shaped groove satisfies with a following formular: N=ROUNDUP(Δ*H*/Δ*h*); a function that rounds a number up to an integer is defined as ROUNDUP; a theoretical depth of the sinking structure is defined as Δ*H*; and the allowable depth of the substrate is defined as Δ*h.*

In a second aspect, an optical waveguide is provided in the present disclosure, which includes: a waveguide substrate; and a coupling grating, wherein the coupling grating is prepared on the waveguide substrate via the nano imprint master described above by method of nano imprint.

In a third aspect, a method for preparing the nano imprint master is further provided by the present disclosure, which includes:
step S100: calculating a theoretical depth Δ*H* of a sinking structure according to a following formula: Δ*H=*H1*(1-L/P), wherein a height of a grating in the grating structure region is defined as *H*₁, a line width of a gritting in the grating structure region is defined as *L*, and a period of a grating in the grating structure region is defined as *P*;
step S200: obtaining an allowable depth Δ*h* of a substrate on the basis of a material of the substrate and a thickness of the substrate;
step S300: comparing the allowable depth Δ*h* of the substrate with the theoretical depth Δ*H* of the sinking structure;
step S400: when the allowable depth Δ*h* of the substrate is greater than or equal to the theoretical depth Δ*H* of the sinking structure, not providing the sinking structure disposed on a position of a non-grating structure region adjacent to the grating structure region; optionally, etching a position on a non-grating structure region adjacent to the grating structure region to form an independent ring-shaped groove, wherein a depth of the ring-shaped groove is equal to the theoretical depth of the sinking structure; and
step S500: when the allowable depth Δ*h* of the substrate is less than the theoretical depth Δ*H* of the sinking structure, providing a sinking structure at a position on the non-grating structure region adjacent to the grating structure region.

In some embodiments, the step S500 includes:
step S510: rounding a valve of Δ*H*/Δ*h* down to an integer, so as to obtain the number *N* of the ring-shaped groove in the sinking structure; and
step S520: etching the position adjacent to the grating structure region on the non-grating structure region to form a plurality of ring-shaped grooves, wherein the number of the plurality of ring-shaped grooves is *N,* and the number *N* of the plurality of ring-shaped grooves is a positive integer.

In some embodiments, the step S500 includes:
step S510': adjusting the material of the substrate and the thickness of the nano imprint master, so as to adjust the allowable depth of the substrate to obtain a tolerance improvement depth Δ*h'* of the substrate;
step S520': when the tolerance improvement depth Δ*h'* of the substrate is greater than or equal to the theoretical depth Δ*H* of the sinking structure, not providing the sinking structure disposed on a position of a non-grating structure region adjacent to the grating structure region; optionally, etching a position on a non-grating structure region adjacent to the grating structure region to form an independent ring-shaped groove, wherein a depth of the ring-shaped groove is equal to the theoretical depth of the sinking structure;
step S530': when the tolerance improvement depth Δ*h'* of the substrate is less than or equal to the theoretical depth Δ*H* of the sinking structure, rounding a valve of Δ*H*/Δ*h'* down to an integer, so as to obtain the number N of the ring-shaped groove in the sinking structure; and
step S540': etching the position adjacent to the grating structure region on the non-grating structure region to form a plurality of ring-shaped grooves, wherein the number of the plurality of ring-shaped grooves is *N,* and the number *N* of the plurality of ring-shaped grooves is a positive integer.

In some embodiments, when the number *N* of the plurality of ring-shaped grooves is 1, the depth of the ring-shaped is equal to the theoretical depth of the sinking structure. When the number *N* of the plurality of ring-shaped grooves is greater than or equal to 2, the plurality of the ring-shaped grooves are in communication with each other, depths of the plurality of ring-shaped grooves successively reduces from the inside out, and a depth difference of adjacent two of the plurality of ring-shaped grooves is equal to the allowable depth of the substrate.

In a fourth aspect, a method for preparing the optical waveguide is further provided in the present disclosure, which includes:
preparing the nano imprint master by the method for preparing the nano imprint master described above,
imprinting a substrate base via the nano imprint master, so as to prepare the nano imprint substrate after a solidifying process; and
imprinting a waveguide substrate via the nano imprint substrate, so as to obtain the optical waveguide after a solidifying process.

Details of one or more embodiments of the present disclosure are presented in the following accompanying drawings and description in order to make other features, purposes and advantages of the present disclosure more concise and understandable.

### BRIEF DESCRIPTION OF THE DRAWINGS

In order to more clearly illustrate the technical solutions in the embodiments of the present disclosure or in the related art, the accompanying drawings to be used in the description of the embodiments or the conventional technology will be briefly described below. Obviously, the accompanying drawings in the following description are only embodiments of the present application, and other accompanying drawings may be obtained by a person of ordinary skill in the art based on the disclosed accompanying drawings without creative labor.
FIG. 1 is a structural schematic diagram of a nano imprint master in an embodiment of the present disclosure.
FIG. 2 is a first example of a nano imprint master in the embodiments of the present disclosure.
FIG. 3 is a partial enlarged diagram of S portion in the nano imprint master of FIG. 2.
FIG. 4 is a second example of a nano imprint master in the embodiments of the present disclosure.
FIG. 5 is a flow diagram of a method for preparing a nano imprint master in an embodiment of the present disclosure.
FIG. 6 is a first example of step S500 in a method for preparing a nano imprint master in the embodiments of the present disclosure.
FIG. 7 is a second example of step S500 in a method for preparing a nano imprint master in the embodiments of the present disclosure.
FIG. 8 is a structural schematic diagram of an optical waveguide in an embodiment of the present disclosure.
FIG. 9 is a flow diagram of a method for preparing an optical waveguide in an embodiment of the present disclosure.
FIG. 10 is an example of a method for preparing an optical waveguide in the embodiments of the present disclosure.

In the figures, 10 represents a nano imprint master; 11 represents a grating structure region; 111 represents an in-coupling grating structure region; 112 represents an out-coupling grating structure region; 12 represents a non-grating structure region; 13 represents a sinking structure; 130 represents a ring-shaped groove; 131 represents an in-coupling sinking structure; 132 represents an out-coupling sinking structure; 20 represents an optical waveguide; 21 represents a waveguide substrate; 211 represents a waveguide support; 212 represents a waveguide glue; 22 represents a coupling grating; 221 represents an in-coupling grating; 222 represents an out-coupling grating; 30 represents a nano imprint substrate; 300 represents a substrate base; 31 represents a substrate support; and 32 represents a substrate glue.

The above description of the main callouts is further described in detail in the present disclosure in conjunction with the accompanying drawings and specific embodiments.

### DETAILED DESCRIPTION

The technical solutions in the embodiments of the present disclosure will be clearly and completely described below in conjunction with the accompanying drawings in the embodiments of the present disclosure. Obviously, the described embodiments are only a part of the embodiments of the present disclosure, and not all of the embodiments. Based on the embodiments in the present disclosure, all other embodiments obtained by a person of ordinary skill in the art without making creative labor fall within the scope of protection of the present disclosure.

It should be understood by a person of ordinary skill in the art that, in the disclosure of the present disclosure, the orientation or positional relationship indicated by the term "longitudinal", "transverse", "above", "beneath", "front", "behind", "left", "right", "vertical", "horizontal", "top," "bottom," "inside," "outside" and the like is based on the orientation or positional relationship shown in the accompanying drawings, which are only for the purpose of facilitating the description of the present disclosure and simplifying the description, and is not intended to indicate or imply that the device or element referred to must have a specific orientation, be constructed and operated with a specific orientation, and therefore, the said terminology is not to be construed as a limitation of the present disclosure.

For the purposes of the present disclosure, the term "a" in the claims and specification should be understood to mean "one or more", i.e., in one embodiment, the number of an element may be one, and in another embodiment, the number of the element may be more than one. The term "a" is not to be understood as unique or singular, and the term "a" is not to be understood as a limitation on the number of elements, unless the disclosure of the present disclosure explicitly indicates that the number of elements is only one.

In the description of the present disclosure, it is to be understood that the terms belonging to "first", "second", and the like are used for descriptive purposes only, and are not to be understood as indicative of, or suggestive of, relative importance. In the description of the present disclosure, it is to be clarified that, unless otherwise expressly specified or limited, the terms "connected" and "fixed" are to be broadly construed. For example, the connection may be a fixed connection, a detachable connection or a connection in one piece; a mechanical connection or an electrical connection; a direct connection or an indirect connection through a medium. For those of ordinary skill in the art, the specific meaning of the above terms in the present disclosure may be understood on a case-by-case basis.

In the description of the present specification, the description with reference to the term "an embodiment" "some embodiments", "examples", "specific examples", or "specific embodiment" and the like means that a specific feature, structure, material, or characteristic described in conjunction with the embodiment or example is included in at least one embodiment or example of the present disclosure. In the present specification, schematic expressions of the above terms do not necessarily refer to the same embodiment or example. Moreover, the specific features, structures, materials, or characteristics described may be combined in a suitable manner in any one or more of the embodiments or examples. Furthermore, without contradicting each other, those skilled in the art may combine and combine different embodiments or examples and features of different embodiments or examples described in the present disclosure.

Inventor of the present disclosure finds that in the process of the nano imprint technology, defects of poor edges and uneven residual adhesive in the grating structure region are mainly caused by following reasons: when a substrate is used to imprinted a product, since a height difference between a top portion of a grating in the grating structure region and a top of a glue layer in the non-grating structure region is relatively great and a thickness of a glue layer of the product is relatively thin, the substrate located around the grating structure region cannot fit with the substrate, poor edges are formed and a ring-shaped defect region is formed, which seriously affects the product appearance and an optical display performance of the product; and in an imprinting and fitting process, the substrate at an edge of the grating structure region curves and deforms, resulting in edge of the grating structure region cannot be fully filled with glue, thus resulting in uneven residual adhesive, which will further affect the optical display performance of the product.

In order to solve the problem, a nano imprint master, an optical waveguide and a method for preparing the same are provided in the present disclosure, which can solve the problem of poor edge and uneven residual adhesive in the grating structure region in the nano imprint technology, improve the optical display performance of the product and improve the appearance of the product.

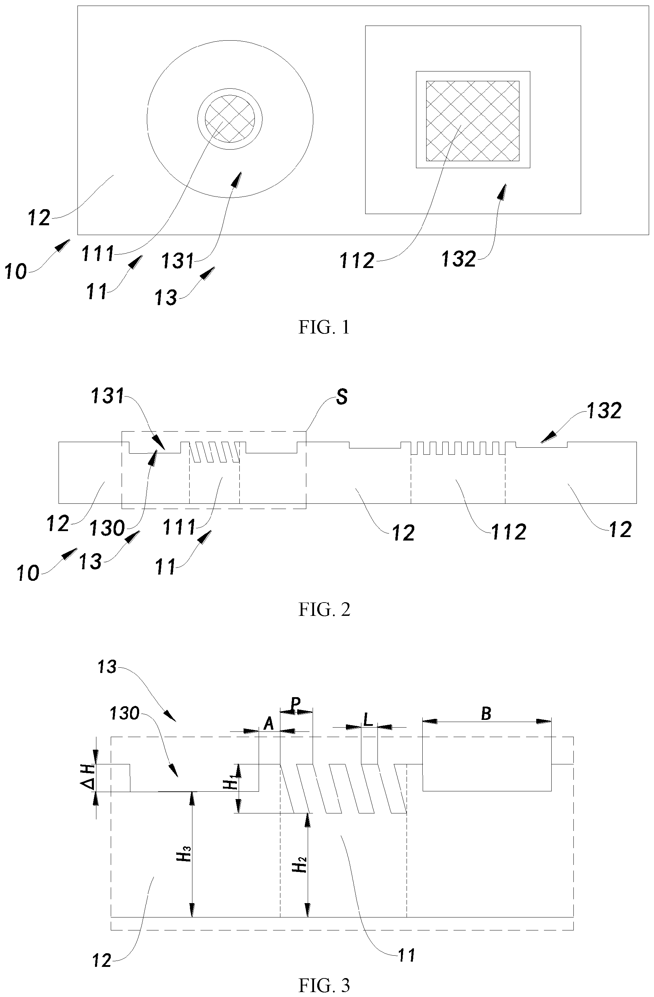

Referring to FIG. 1 to FIG. 4 of the present disclosure, a nano imprint master 10 is provided according to an embodiment of the present disclosure, which includes: a grating structure region 11; a non-grating structure region 12 disposed around the grating structure region 11; and a sinking structure 13. The sinking structure 13 is disposed at a position adjacent to the grating structure region 11 in the non-grating structure region 12, and the sinking structure 13 extends around a circumference of the grating structure region 11 to surround the grating structure region 11.

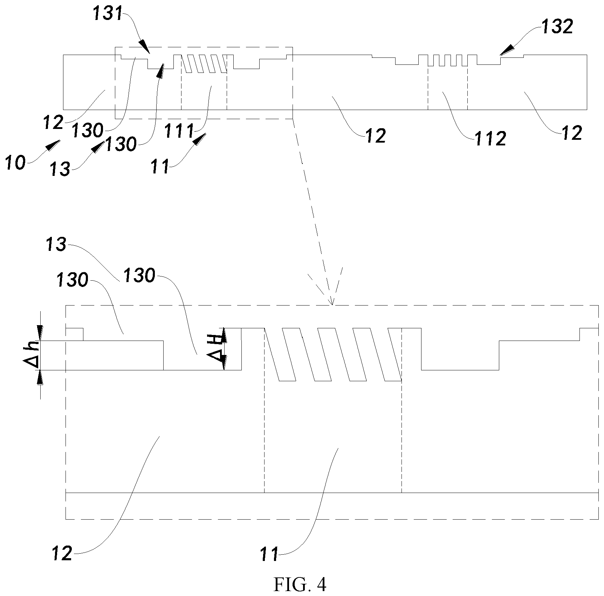

Referring to FIG. 2 and FIG. 4, the nano imprint master 10 includes one grating structure region 11 or a plurality of grating structure regions 11. At this time, the nano imprint master 10 is provided with a corresponding number of sinking structure 13, and the sinking structure 13 are disposed around the grating structure region and each to each corresponding to the grating structure region 11. For example, the nano imprint mater 10 can include an in-coupling grating structure region 111 and an out-coupling grating structure region 112 disposed at intervals, both a periphery of the in-coupling grating structure region 111 and a periphery of the out-coupling grating structure region 112 are subjected to a sinking process, so as to obtain an in-coupling sinking structure 131 surrounded the in-coupling grating structure region 111 and an out-coupling sinking structure 132 surrounded the out-coupling grating region 112, thereby ensuring that the in-coupling grating and the out-coupling grating made by method of imprinting do not have the problem of poor edge and uneven residual adhesive.

It should be noted that in the nano imprint master 10, since the sinking structure 13 is disposed at a position adjacent to the grating structure region 11 in the non-grating structure region 12, a height difference between the top of a grating imprinted by the nano imprint master 10 and a top of the glue layer of the non-grating structure region is reduced. Thus, the poor edge and uneven residual adhesive of the grating structure region caused by unduly great height difference can be lowered or eliminated.

In some embodiments, referring to FIG. 3, a distance between an inner edge of the sinking structure 13 and an outer edge of the grating structure region 11 is defined as *A,* and the distance *A* between the inner edge of the sinking structure 13 and the outer edge of the grating structure region 11 is in a range of 0.01 µm to 1000 µm, so as to protect the grating structure in the grating structure region 11 from being damaged. It could be understood that the distance *A* between the inner edge of the sinking structure 13 and the outer edge of the grating structure region 11 can be adjusted according to factors such as a fillibility of the material of the substrate and a thickness of the substrate, and the like, which will not be repeated herein.

In some embodiments, referring to FIG. 3, a processing width of the sinking structure 13 is defined as *B,* and the processing width *B* of the sinking structure 13 greater than or equal to 0.01 µm, so as to avoid poor ring-shaped caused by unduly less processing width *B* of the sinking structure 13. It could be understood that the processing width *B* of the sinking structure 13 is related to a firmness of the material of the substrate. That is, the greater the firmness of the material of is, the greater the processing width *B* of the sinking structure 13 is.

In some embodiments, the processing width *B* of the sinking structure 13 is smaller than or equal to a width of the non-grating structure region 12. That is, the sinking structure 13 can cover at most the entire of the non-grating structure region 12. In some embodiments, the processing width *B* of the sinking structure 13 is generally smaller than or equal to 30 cm.

In some embodiments, a processing depth of the sinking structure 13 is in a range of 0.01 µm to 100 µm, so as to ensure that the substrate can be in tightly connection with the imprinting substrate (e.g., a waveguide substrate).

It should be noted that, referring to FIG. 3, a processing depth of the sinking structure 13 can be defined according to a theoretical depth Δ*H* of the sinking structure 13. The theoretical depth Δ*H* of the sinking structure 13 can be obtained according to a height *H*₁ of a grating of the actual product, a thickness *H*₂ of the residual adhesive, and an imprinting thickness *H*₃ of the non-grating structure region, and the height *H*₁ of the grating of the actual product, the thickness *H*₂ of the residual adhesive, and the imprinting thickness *H*₃ of the non-grating structure region satisfy with following formulas: Δ*H*=*H*₁+*H*₂-*H*₃; and *H*₁**L+P*H*₂=*H*₃**P.* A line width of a gritting in the grating structure region is defined as *L*, and a period of a grating in the grating structure region is defined as *P*.

That is, the theoretical depth Δ*H* of the sinking structure 13 satisfies with a following formula: Δ*H=H*1***(1-L/P); a height of a grating in the grating structure region 11 is defined as *H*₁, a line width of a gritting in the grating structure region 11 is defined as *L*, and a period of a grating in the grating structure region 11 is defined as *P*.

It could be understood that a sum of a height of the grating in the grating structure region of the actual produce and a thickness of the residual adhesive of the actual product is greater than an imprinting thickness of the non-grating structure region, and a height difference therebetween is defined as a theoretical depth Δ*H* of the sinking structure 13 in the present disclosure. Whether poor ring-shaped may be occurred is depended on both the theoretical depth Δ*H* of the sinking structure 13 and the allowable depth Δ*h* of the substrate, the allowable depth Δ*h* of the substrate is defined by the material of the substrate and the thickness of the substrate. If the allowable depth Δ*h* of the substrate is greater than or equal to the theoretical depth Δ*H* of the sinking structure 13, situation of poor ring-shaped will not occur without the sinking structure. If the allowable depth Δ*h* of the substrate is less than the theoretical depth Δ*H* of the sinking structure 13, the sinking structure should be provided to avoid occasion of poor ring-shaped.

It should be noted that in order to further improving the problem of uneven residual adhesive, the nano imprint master 10 in the present disclosure can be provided with the sinking structure 13 even when the allowable depth Δ*h* of the substrate is greater than or equal to the theoretical depth *ΔH.*

In a first embodiment of the present disclosure, referring to FIG. 2 and FIG. 3, the sinking structure 13 includes an independent ring-shaped groove curving from a surface of the non-grating structure region 12, so as to surround the grating structure region 11. Thus, there is a buffer between a height of a top of the grating after the imprinting process and a height of the top of the glue layer of the non-grating structure, so that situation that the substrate cannot contact the imprinting substrate caused by unduly great height difference can be avoided, thereby avoiding defects such as uneven residual adhesive at the edge of the grating structure region

In some embodiments, referring to FIG. 3, a depth of the ring-shaped groove 130 is equal to a theoretical depth Δ*H* of the sinking structure 13. It could be understood that in some embodiments of the present disclosure the depth of the ring-shaped groove 130 can be greater than the theoretical depth Δ*H* of the sinking structure 13, as long as the depth of the ring-shaped groove 130 is not greater than the allowable depth Δ*h* of the substrate.

It should be noted that when the allowable depth Δ*h* of the substrate is less than the theoretical depth Δ*H* of the sinking structure 13, the sinking structure 13 merely includes an independent ring-shaped groove. Thus, the depth of the ring-shaped groove is greater than the allowable depth Δ*h* of the substrate, and the problem of poor ring-shaped may still occur. In this way, in a second embodiment of the present disclosure, referring to FIG. 4, the sinking structure 13 includes a plurality of ring-shaped grooves 130 curving from a surface of the non-grating structure region 12, and the plurality of ring-shaped grooves 130 are in communication with each other, and depths of the plurality of ring-shaped grooves 130 successively reduces from the inside out to define a step-shaped groove, so as to overcome the defect of poor ring-shaped structure caused by unduly deep depth of the ring-shaped groove.

In some embodiments, referring to FIG. 4, a depth difference of adjacent two of the plurality of ring-shaped grooves 130 can be equal to the allowable depth Δ*h* of the substrate, so as to avoid the problem of poor ring-shaped caused by a situation that a depth difference of adjacent two of the plurality of ring-shaped grooves 130 is greater than the allowable depth Δ*h* of the substrate.

In some embodiments, the number of the plurality of ring-shaped grooves 130 is defined as N, and the number N of the plurality of ring-shaped grooves satisfies with a following formular: N=ROUNDUP(Δ*H*/Δ*h*); a function that rounds a number up to an integer is defined as ROUNDUP; a theoretical depth of the sinking structure is defined as Δ*H*; and the allowable depth of the substrate is defined as Δ*h.* In this way, the number N of the plurality of ring-shaped grooves 130 is a positive integer greater than 1. For example, when Δ*H*/Δ*h* is equal to 1.2, the number *N* of the plurality of ring-shaped grooves 130 is 2; and when Δ*H*/Δ*h* is equal to 2.5, the number *N* of the plurality of ring-shaped grooves 130 is 3. Thus, the depth difference of adjacent two of the plurality of ring-shaped grooves 130 can be ensured to be not greater than the allowable depth Δ*h* of the substrate

In view of above, the sinking structure 13 in the present disclosure can be but is not limited to one or a plurality of ring-shaped grooves 130 disposed on the non-grating structure region 12 by method of etching. It could be understood that the ring-shaped in the present disclosure is not limited to circular-shaped ring, but also can be rectangle-shaped ring or other ring-shaped structures, as long as the ring-shaped structure fits with a shape of the grating structure region 11, which will not be limited in the present disclosure.

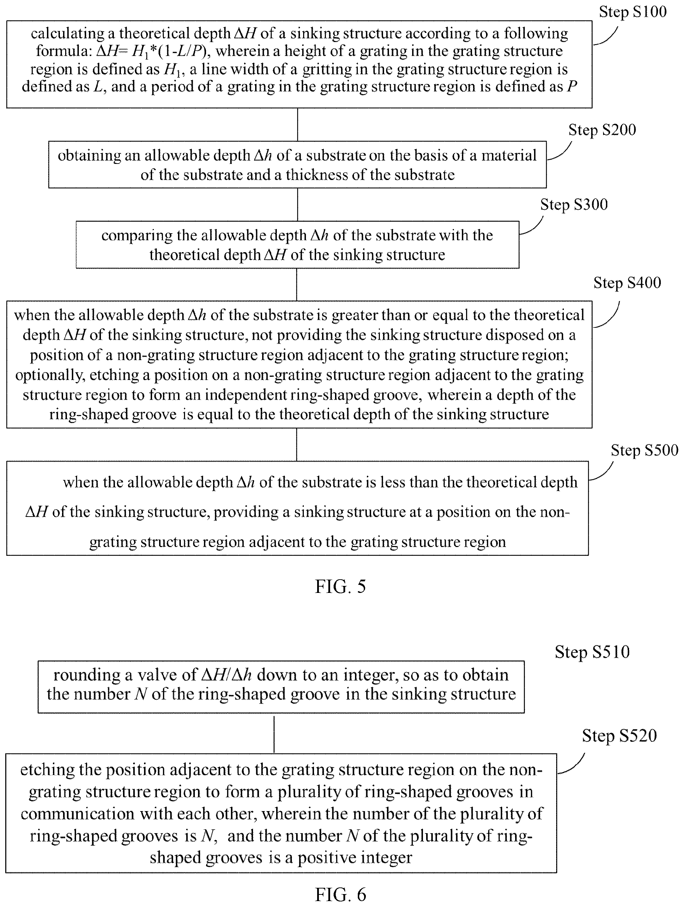

In a second aspect, referring to FIG. 5, a method for preparing a nano imprint master is further provided in an embodiment of the present disclosure, which includes;
step S100: calculating a theoretical depth Δ*H* of a sinking structure according to a following formula: Δ*H*=H1*(1-L/P), wherein a height of a grating in the grating structure region is defined as *H*₁, a line width of a gritting in the grating structure region is defined as *L*, and a period of a grating in the grating structure region is defined as*P*;
step S200: obtaining an allowable depth Δ*h* of a substrate on the basis of a material of the substrate and a thickness of the substrate;
step S300: comparing the allowable depth Δ*h* of the substrate with the theoretical depth Δ*H* of the sinking structure;
step S400: when the allowable depth Δ*h* of the substrate is greater than or equal to the theoretical depth Δ*H* of the sinking structure, not providing the sinking structure disposed on a position of a non-grating structure region adjacent to the grating structure region; optionally, etching a position on a non-grating structure region adjacent to the grating structure region to form an independent ring-shaped groove, wherein a depth of the ring-shaped groove is equal to the theoretical depth of the sinking structure; and
step S500: when the allowable depth Δ*h* of the substrate is less than the theoretical depth Δ*H* of the sinking structure, providing a sinking structure at a position on the non-grating structure region adjacent to the grating structure region.

It should be noted that in step S400, when the allowable depth Δ*h* of the substrate is greater than or equal to the theoretical depth Δ*H* of the sinking structure, the nano imprint master can be provided without a sinking structure, or can be provided with an independent ring-shaped groove, and both of which can avoid occasion of the problem of poor ring-shaped.

In some embodiments, in a first example of the present disclosure, referring to FIG. 6, the step S500 includes:
step S510: rounding a valve of Δ*H*/Δ*h* up to an integer, so as to obtain the number *N* of the ring-shaped groove in the sinking structure; and
step S520: etching the position adjacent to the grating structure region on the non-grating structure region to form a plurality of ring-shaped grooves in communication with each other, wherein the number of the plurality of ring-shaped grooves is *N*, depths of the plurality of ring-shaped grooves successively reduces from the inside out, and a depth difference of adjacent two of the plurality of ring-shaped grooves is equal to the allowable depth of the substrate.

It should be noted that since the allowable depth Δ*h* of the substrate is determined by the material of the substrate and the thickness of the substrate, the allowable depth of the substrate can be improved by adjusting a material of the substrate (such as a type of the glue) and/or a thickness of the substrate, so as to obtain a tolerance improvement depth Δ*h'* of the substrate greater than the allowable depth Δ*h* of the substrate. At this time, when the tolerance improvement depth Δ*h'* of the substrate is greater than or equal to the theoretical depth Δ*H* of the sinking structure, the nano imprint master can be provided without a sinking structure, or can be provided with an independent ring-shaped groove, and both of which can solve the problem of poor ring-shaped; and when the tolerance improvement depth Δ*h'* of the substrate is less than the theoretical depth Δ*H* of the sinking structure, the nano imprint master should be provided with a plurality of ring-shaped grooves to form a step-shaped groove to solve the problem of poor ring-shaped.

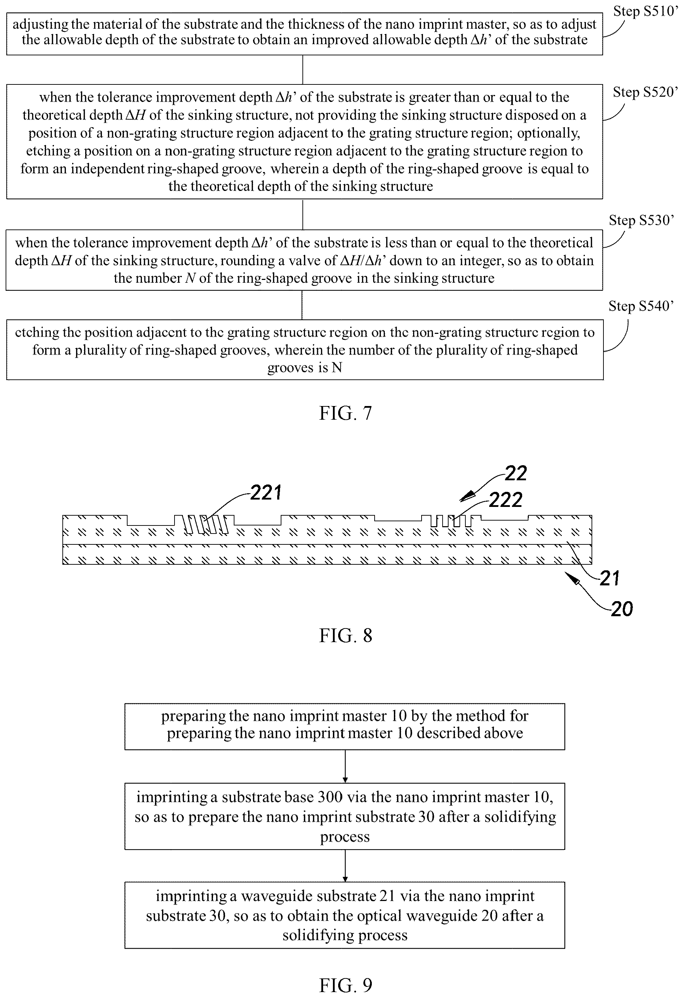

In a second example of the present disclosure, referring to FIG. 7, the step S500 includes:
step S510': adjusting the material of the substrate and the thickness of the nano imprint master, so as to adjust the allowable depth of the substrate to obtain a tolerance improvement depth Δ*h'* of the substrate;
step S520': when the tolerance improvement depth Δ*h'* of the substrate is greater than or equal to the theoretical depth Δ*H* of the sinking structure, not providing the sinking structure disposed on a position of a non-grating structure region adjacent to the grating structure region; optionally, etching a position on a non-grating structure region adjacent to the grating structure region to form an independent ring-shaped groove, wherein a depth of the ring-shaped groove is equal to the theoretical depth of the sinking structure;
step S530': when the tolerance improvement depth Δ*h'* of the substrate is less than or equal to the theoretical depth Δ*H* of the sinking structure, rounding a valve of Δ*H*/Δ*h'* up to an integer, so as to obtain the number *N* of the ring-shaped groove in the sinking structure, wherein the number *N* of the ring-shaped groove is a positive integer greater than or equal to 1; and
step S540': etching the position adjacent to the grating structure region on the non-grating structure region to form a plurality of ring-shaped grooves in communication with each other, wherein the number of the plurality of ring-shaped grooves is N, depths of the plurality of ring-shaped grooves successively reduces from the inside out, and a depth difference of adjacent two of the plurality of ring-shaped grooves is equal to the allowable depth of the substrate.

In a third aspect, referring to FIG. 8, an optical waveguide 20 is further provided in an embodiment of the present disclosure. The optical waveguide 20 can include a waveguide substrate 21 and a coupling grating 22. The coupling grating 22 can be formed on the waveguide substrate 21 via the nano imprint master 10 by method of nano imprint, so as to ensure that the teeth at the edge of the coupling grating 22 has a better restoring effect, and the problem of poor edge or uneven residual adhesive is lowered or eliminated.

In some embodiments, referring to FIG. 8, the coupling grating 22 can an include in-coupling grating 221 and an out-coupling grating 222 disposed on the waveguide substrate 21 at intervals, and the in-coupling grating 221 and the out-coupling grating 222 are each to each corresponding to the in-coupling grating structure region 111 and the out-coupling grating structure region 112 in the nano imprint master 10. It should be noted that the coupling grating 22 can be a mydriatic grating located between the in-coupling grating 221 and the out-coupling grating 222. Correspondingly, the nano imprint master 10 can be provided with a mydriatic grating structure region corresponding to the mydriatic grating, which will not be repeated herein.

In a fourth aspect, referring to FIG. 9, a method for preparing the optical waveguide is further provided in an embodiment of the present disclosure. The method includes following steps:
preparing the nano imprint master 10 by the method for preparing the nano imprint master 10 described above;
imprinting a substrate base 300 via the nano imprint master 10, so as to prepare the nano imprint substrate 30 after a solidifying process; and
imprinting a waveguide substrate 21 via the nano imprint substrate 30, so as to obtain the optical waveguide 20 after a solidifying process.

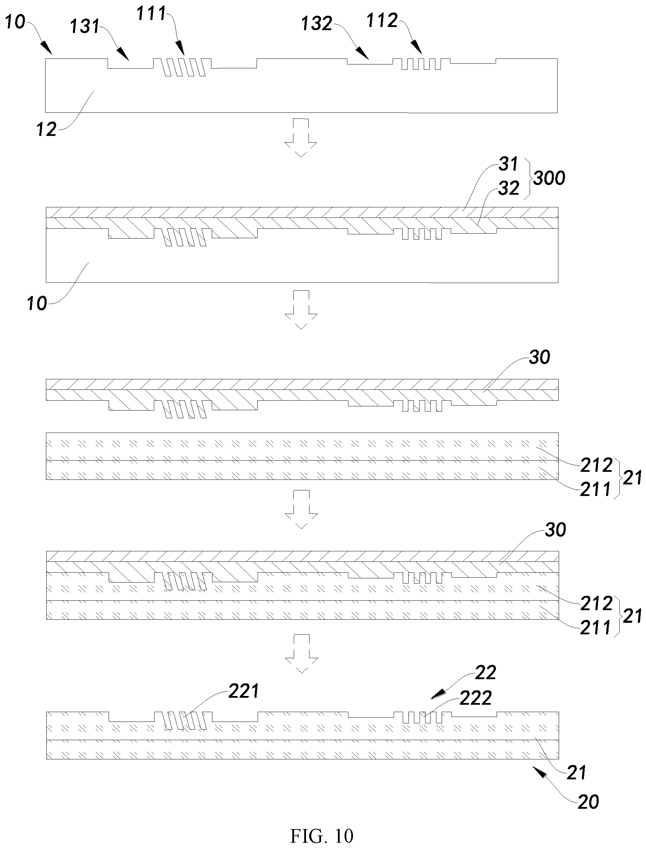

Referring to FIG. 10, in the present disclosure, the substrate base can include a substrate support and a substrate glue 32 coated on the substrate support. The nano imprint master 10 is imprinted on the substrate glue 32 of the substrate base 300, so as to obtain the nano imprint substrate 30 after the substrate glue 32 is solidified.

Similarly, referring to FIG. 10, in the present disclosure, before the process of solidifying, the waveguide substrate 21 can include a waveguide support 211 and a waveguide glue 212 coated on the waveguide support 211. The nano imprint substrate 30 is imprinted on the waveguide glue 212 of the waveguide substrate 21, so as to obtain the optical waveguide 20 after the waveguide glue 212 is solidified.

The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present disclosure.

The above-described embodiments are only several implementations of the present disclosure, and the descriptions are relatively specific and detailed, but they should not be construed as limiting the scope of the present disclosure. It should be understood by those of ordinary skill in the art that various modifications and improvements can be made without departing from the concept of the present disclosure, and all fall within the protection scope of the present disclosure. Therefore, the patent protection of the present disclosure shall be defined by the appended claims.

## Claims

1. A nano imprint master **characterized by** comprising
a grating structure region;
a non-grating structure region, wherein the non-grating structure region is disposed around the grating structure region; and
a sinking structure, wherein the sinking structure is disposed at a position adjacent to the grating structure region in the non-grating structure region, and the sinking structure extends around a circumference of the grating structure region to surround the grating structure region.

2. The nano imprint master of claim 1, wherein a distance between an inner edge of the sinking structure and an outer edge of the grating structure region is in a range of 0.01 µm to 1000 µm.

3. The nano imprint master of claim 1, wherein a processing width of the sinking structure is greater than or equal to 0.01 µm.

4. The nano imprint master of claim 1, wherein a processing depth of the sinking structure is in a range of 0.01 µm to 100 µm.

5. The nano imprint master of any one of claims 1 to 4, wherein the sinking structure comprises an independent ring-shaped groove curving from a surface of the non-grating structure region.

6. The nano imprint master of claim 5, wherein a depth of the ring-shaped groove is equal to a theoretical depth of the sinking structure.

7. The nano imprint master of claim 6, wherein the theoretical depth of the sinking structure is defined as Δ*H,* and the theoretical depth Δ*H* of the sinking structure satisfies with a following formula: Δ*H=*H1***(1-L/P); a height of a grating in the grating structure region is defined as *H*₁, a line width of a gritting in the grating structure region is defined as *L*, and a period of a grating in the grating structure region is defined as *P*.

8. The nano imprint master of any one of claims 1 to 4, wherein the sinking structure comprises a plurality of ring-shaped grooves curving from a surface of the non-grating structure region, and the plurality of ring-shaped grooves are in communication with each other, and depths of the plurality of ring-shaped grooves successively reduces from the inside out to define a step-shaped groove.

9. The nano imprint master of claim 8, wherein a depth difference of adjacent two of the plurality of ring-shaped grooves is equal to an allowable depth of a substrate, and an allowable depth of the substrate is defined by a material of the substrate and a thickness of the substrate.

10. The nano imprint master of claim 8, wherein the number of the plurality of ring-shaped grooves is defined as N, and the number N of the plurality of ring-shaped grooves satisfies with a following formular: N=ROUNDUP(Δ*H*/Δ*h*); a function that rounds a number up to an integer is defined as ROUNDUP; a theoretical depth of the sinking structure is defined as Δ*H*; and the allowable depth of the substrate is defined as Δ*h.*

11. An optical waveguide, **characterized by** comprising
a waveguide substrate; and
a coupling grating, wherein the coupling grating is prepared on the waveguide substrate via the nano imprint master of any one of claims 1 to 10 by method of nano imprint.

12. A method for preparing the nano imprint master, **characterized by** comprising:
step S100: calculating a theoretical depth Δ*H* of a sinking structure according to a following formula: Δ*H*=H1***(1-L/P)*,* wherein a height of a grating in the grating structure region is defined as *H*₁, a line width of a gritting in the grating structure region is defined as *L*, and a period of a grating in the grating structure region is defined as *P*;
step S200: obtaining an allowable depth Δ*h* of a substrate on the basis of a material of the substrate and a thickness of the substrate;
step S300: comparing the allowable depth Δ*h* of the substrate with the theoretical depth Δ*H* of the sinking structure;
step S400: when the allowable depth Δ*h* of the substrate is greater than or equal to the theoretical depth Δ*H* of the sinking structure, not providing the sinking structure disposed on a position of a non-grating structure region adjacent to the grating structure region; optionally, etching a position on a non-grating structure region adjacent to the grating structure region to form an independent ring-shaped groove, wherein a depth of the ring-shaped groove is equal to the theoretical depth of the sinking structure; and
step S500: when the allowable depth Δ*h* of the substrate is less than the theoretical depth Δ*H* of the sinking structure, providing a sinking structure at a position on the non-grating structure region adjacent to the grating structure region.

13. The method for preparing the nano imprint master of claim 12, wherein the step S500 comprises:
step S510: rounding a valve of Δ*H*/Δ*h* up to an integer, so as to obtain the number *N* of the ring-shaped groove in the sinking structure, wherein the number *N* of the ring-shaped groove in the sinking structure is a positive integer greater than or equal to 1; and
step S520: etching the position adjacent to the grating structure region on the non-grating structure region to form a plurality of ring-shaped grooves in communication with each other, wherein the number of the plurality of ring-shaped grooves is N, depths of the plurality of ring-shaped grooves successively reduces from the inside out, and a depth difference of adjacent two of the plurality of ring-shaped grooves is equal to the allowable depth of the substrate.

14. The method for preparing the nano imprint master of claim 12, wherein the step S500 comprises:
step S510': adjusting the material of the substrate and the thickness of the nano imprint master, so as to adjust the allowable depth of the substrate to obtain an improved allowable depth Δ*h'* of the substrate;
step S520': when the tolerance improvement depth Δ*h'* of the substrate is greater than or equal to the theoretical depth Δ*H* of the sinking structure, not providing the sinking structure disposed on a position of a non-grating structure region adjacent to the grating structure region; optionally, etching a position on a non-grating structure region adjacent to the grating structure region to form an independent ring-shaped groove, wherein a depth of the ring-shaped groove is equal to the theoretical depth of the sinking structure;
step S530': when the tolerance improvement depth Δ*h'* of the substrate is less than or equal to the theoretical depth Δ*H* of the sinking structure, rounding a valve of Δ*H*/Δ*h'* up to an integer, so as to obtain the number *N* of the ring-shaped groove in the sinking structure, wherein the number *N* of the ring-shaped groove is a positive integer greater than or equal to 1; and
step S540': etching the position adjacent to the grating structure region on the non-grating structure region to form a plurality of ring-shaped grooves in communication with each other, wherein the number of the plurality of ring-shaped grooves is N, depths of the plurality of ring-shaped grooves successively reduces from the inside out, and a depth difference of adjacent two of the plurality of ring-shaped grooves is equal to the allowable depth of the substrate.

15. A method for preparing the optical waveguide, **characterized by** comprising
preparing the nano imprint master by the method for preparing the nano imprint master of any one of claims 12 to 14,
imprinting a substrate base via the nano imprint master, so as to prepare the nano imprint substrate after a solidifying process; and
imprinting a waveguide substrate via the nano imprint substrate, so as to obtain the optical waveguide after a solidifying process.
